# EUROPEAN PATENT APPLICATION

(11) **EP 4 525 110 A1**
(43) Date of publication of application: **19.03.2025**
(21) Application number: 23852894.7
(22) Date of filing: 04.08.2023
(51) Int. Cl.: H01M 10/04, H01M 10/42

(54) **BATTERY CELL INSPECTION DEVICE**

(30) Priority: 08.08.2022 KR 20220098625; 02.08.2023 KR 20230101240
(71) Applicant: LG Energy Solution, Ltd., Seoul 07335 (KR)
(72) Inventor: KIM, Jeagyeong, Daejeon 34122 (KR)
(74) Representative: Goddar, Heinz J.
(86) International application number: PCT/KR2023/011486
(87) International publication number: WO 2024/035014

(57) **Abstract**

A battery cell inspection apparatus according to an embodiment of the present disclosure includes pressing plates that press a battery cell, a support member disposed between mutually opposing surfaces of the pressing plates having the battery cell mounted thereon, a gripper capable of gripping and moving the battery cell, and a push member that can protrude from at least one of the pressing plates toward the support member and push the support member.

## Description

### [TECHNICAL FIELD]

### Cross Citation with Related Application(s)

This application claims the benefit of Korean Patent Application No. 10-2022-0098625 filed on August 8, 2022 and Korean Patent Application No. 10-2023-0101240 filed on August 2, 2023 in the Korean Intellectual Property Office, the disclosures of which are incorporated herein by reference in their entirety.

The present disclosure relates to a battery cell inspection apparatus, and more particularly, a battery cell inspection apparatus that prevents the battery cell mounted on the inspection apparatus from being deflected to one side

### [BACKGROUND]

In recent years, there is an urgent need to reduce the amount of carbon dioxide in order to deal with air pollution or global warming issues. In the automobile industry, expectations are rising for the reduction of carbon dioxide emissions through the introduction of electric vehicles (EVs) and hybrid electric vehicles (HEVs), and in order to put them to a practical use, the development and commercialization of secondary batteries is actively progressing.

After the electrode manufacturing and assembly process is completed, in order to inspect the battery cell, the battery cell must be properly mounted on an inspection apparatus. That is, the electrode lead of the battery cell must be disposed in contact with the conductive part of the inspection apparatus to electrically connect the two, and such an electrical connecting state must be maintained while progressing charging/discharging for inspection is in progress.

For this purpose, a battery cell inspection apparatus is generally equipped with a plurality of pressing plates for fixing the battery cells. While sandwiching a pouch-type battery cell between a pair of pressing plates and applying pressure from both sides, leakage current is measured through the battery cell lead.

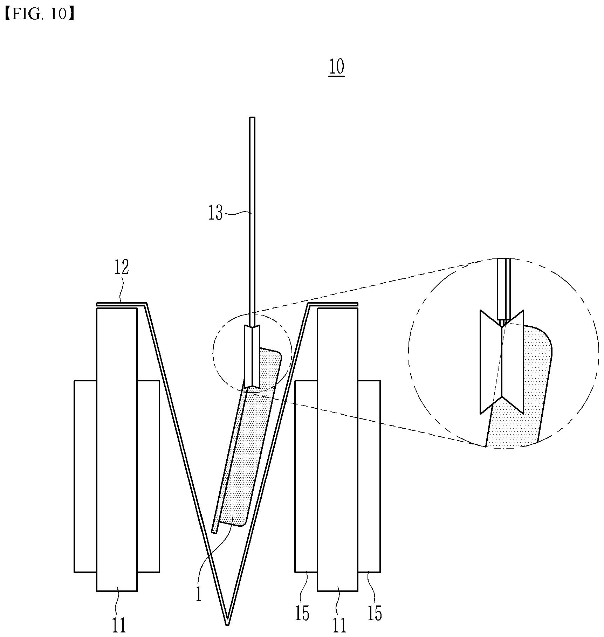

FIG. 10 schematically shows a battery cell inspection apparatus 10 according to the prior art. In the inspection apparatus 10 according to the prior art, when the battery cell 1 is mounted on a support member 12 between pressing plates 11, the center of gravity is deflected to one side, or the battery cell 1 may be deflected to one side due to various reasons such as other process reasons.

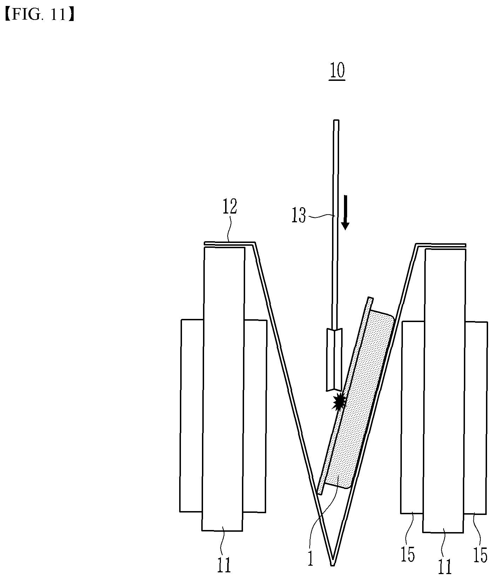

At this time, as shown in FIG. 11, when gripping the battery cell 1 by a gripper 13, taking it out of the pressing plates 11 and trying to move it, the battery cell 1 may not be properly gripped. Therefore, there is a problem that the gripper 13 contacts an area other than the area originally intended to be gripped, thus causing scratch marks on the battery cell 1, or in some cases, there is a possibility that the battery cell 1 might be damaged.

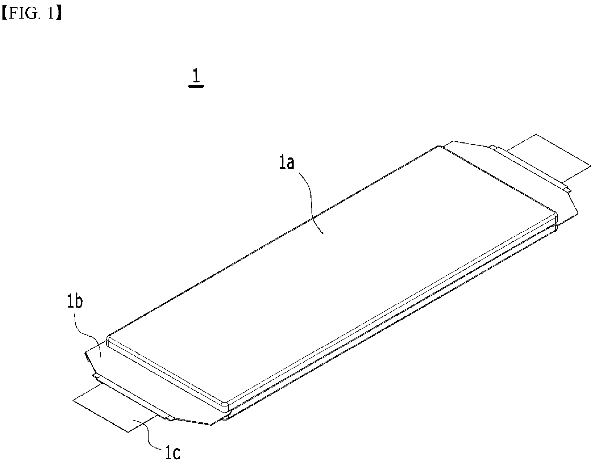

Alternatively, if the battery cell 1 that is deflected to one side is gripped by the gripper 13 at the upper part of the battery cell 1, the terrace part 1b (see FIG. 1) of the battery cell 1 may be folded in some cases. In particular, since the terrace part is a part where multiple electrode tabs and/or electrode leads pass, disconnection may occur due to folding of the terrace part. This may cause serious problems in the operation of the battery cell 1, and thus, when the battery cell 1 is mounted in an inspection apparatus to measure the leakage current, a method for improving the above-mentioned problems is needed.

### [DETAILED DESCRIPTION OF THE INVENTION]

### [Technical Problem]

It is an object of the present disclosure to provide a battery cell inspection apparatus that prevents the battery cell mounted on the inspection apparatus from being deflected to one side

However, the technical problems to be solved by embodiments of the present disclosure are not limited to the above-described problems, and can be variously expanded within the scope of the technical idea included in the present disclosure.

### [Technical Solution]

According to one embodiment of the present disclosure, there is provided a battery cell inspection apparatus comprising: pressing plates that press a battery cell; a support member disposed between mutually opposing surfaces of the pressing plates having the battery cell mounted thereon; a gripper capable of gripping and moving the battery cell; and a push member that can protrude from at least one of the pressing plates toward the support member and push the support member.

The push member may comprise a bar shaped so as to protrude toward the support member from at least one of the mutually opposing surfaces of the pressing plates; and a head part located at one end of the bar and pushing the support member.

The push member can protrude toward the support member between the at least one of mutually opposing surfaces of the pressing plates and the support member, and can retract toward the pressing plate again, so that the mounted battery cell can be prevented from being deflected in one direction.

The push member already protrudes from the pressing plate before the battery cell is mounted on the support member, or the battery cell is mounted on the support member, and simultaneously or subsequently, the push member may protrude from the pressing plate.

During inspection of the battery cell, the push member is pushing the pressing plate in a protruding state.

The push member may be located on an upper part of at least one of the mutually opposing surfaces of the pressing plates.

The support member may comprise a mounting part to which a battery cell is mounted and a fixing part fixed to the pressing plates.

The mounting part of the support member is V-shaped or U-shaped, and the fixing part of the support member may extend from both ends of the mounting part to be fixed to respective upper ends of the pressing plates.

Both ends of the support member may be fixed to the pressing plates, respectively, and the support member may be folded or bent between both fixing parts to mount the battery cell on the support member.

The battery cell inspection apparatus may further comprise buffer members that are respectively provided on mutually opposing surfaces of the pressing plates.

The buffer member may be a urethane pad.

The battery cell may have a main body that protrudes in one direction, and the push member may be provided on the pressing plate toward which the protruding main body of the battery cell is directed.

The battery cell may have a main body that protrudes in both directions, and the push members may be respectively provided on mutually opposing surfaces of the pressing plates.

The push member may be made of stainless steel, and the support member may be made of paper or plastic.

According to another embodiment of the present disclosure, there is provided a battery cell inspection method comprising the steps of: gripping the battery cell by a gripper, mounting the battery cell gripped by the gripper on a support member between pressing plates facing each other, moving the pressing plates toward the battery cell, and inspecting the battery cell while pressing the battery cell with the pressing plates, wherein a push member protrudes from the pressing plate to push the support member so that the mounted battery cell is prevented from being deflected.

The step of mounting the battery cell gripped by the gripper on a support member comprises lowering the battery cell gripped by the gripper onto the support member, wherein the push member already protrudes from the pressing plate before the battery cell is mounted on the support member, or the battery cell is mounted on the support member, and simultaneously or subsequently, the push member protrudes from the pressing plate.

During the step of inspecting the battery cell, the protruding push member may push the pressing plate.

In the step of moving the pressing plates toward the battery cell, and the step of inspecting the battery cell while pressing the battery cell with the pressing plates, the extent to which the push member moves toward the pressing plate again to push the support member can be adjusted.

During the inspecting the battery cell, the state in which the gripper grips the battery cell may be maintained as it is.

Before the step of inspecting the battery cell, the method may comprise releasing the grip of the battery cell and removing the gripper.

### [Advantageous Effects]

According to the present disclosure, when a battery cell is mounted on a support member provided between the pressing plates, a push member is provided that protrudes from the inner surface of at least one pressing plate toward the support member, thereby being able to prevent the battery cell placed on the support member from being deflected to one side, preventing damage to the battery cell that may occur therefrom, and facilitating movement of the battery cell.

The effects of the present disclosure are not limited to the effects mentioned above, and additional other effects not mentioned above will be clearly understood from the description of claims by those skilled in the art.

### [BRIEF DESCRIPTION OF THE DRAWINGS]

FIG. 1 is an illustrative diagram showing a battery cell;
FIG. 2 shows a battery cell inspection apparatus according to an embodiment of the present disclosure;
FIG. 3 shows a battery cell inspection apparatus according to another embodiment of the present disclosure;
FIGS. 4 to 9 illustrate each step in the method of inspecting a battery cell in the battery cell inspection apparatus of FIG. 2;
FIG. 10 shows a battery cell inspection apparatus according to the prior art; and
FIG. 11 shows a case where a scratch occurs on a battery cell in the battery cell inspection device of FIG. 10.

### [DETAILED DESCRIPTION OF THE EMBODIMENTS]

Hereinafter, various embodiments of the present disclosure will be described in detail with reference to the accompanying drawings so that those skilled in the art can easily carry out them. The present disclosure can be modified in various different ways, and is not limited to the embodiments set forth herein.

Portions that are irrelevant to the description will be omitted to clearly describe the present disclosure, and like reference numerals designate like elements throughout the description.

Further, since the size and thickness of each element in the drawings are arbitrarily enlarged or reduced for convenience of description, it is obvious that the present disclosure is not limited to those illustrated in the drawings.

In the present disclosure, when any components are referred to as being "linked" or "connected" to other components, it is to be understood that the components may be directly linked or connected to other components, but another component may intervene therebetween. On the other hand, when any components are "directly linked" or "directly connected" to other components, it is to be understood that there is no another component therebetween.

It will be understood that the terms "comprises" or "have" as used herein specify the presence of stated features, steps, operations, components, parts, or a combination thereof, but do not preclude the presence or addition of one or more other features, numerals, steps, operations, components, parts, or a combination thereof.

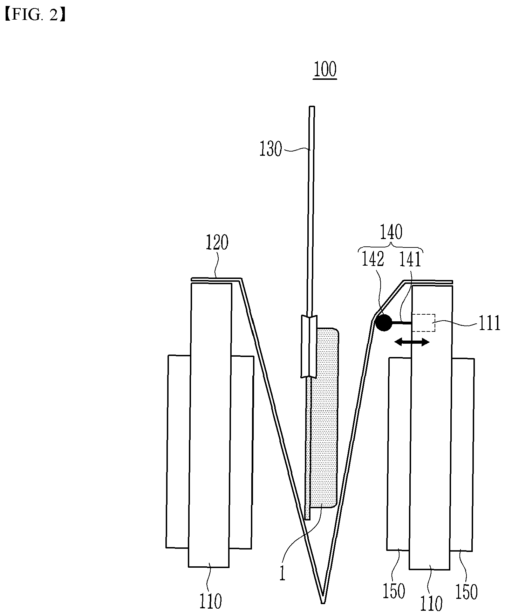

FIG. 1 is an illustrative diagram showing a battery cell 1, which is a diagram showing a pouch-type battery cell having a main body protruding in one direction. The battery cell 1 may be mounted on the battery cell inspection apparatus 100 (see FIG. 2) according to the present disclosure to proceed the inspection process. The battery cell 1 includes a main body 1a, a terrace part 1b, and an electrode lead 1c. The terrace part 1b of the battery cell 1 is an edge part of the heat-sealed pouch exterior material, and refers to a portion from which the electrode lead 1c comes out.

On the other hand, the battery cells that can be inspected by the battery cell inspection apparatus 100 according to an embodiment of the present disclosure are not limited to the pouch-shaped battery cells, and can also be applied to prismatic and cylindrical battery cells.

FIG. 2 shows a battery cell inspection apparatus 100 according to an embodiment of the present disclosure.

The battery cell inspection apparatus 100 according to an embodiment of the present disclosure may be mainly used for performance testing of the battery cell in a formation process after assembly of the battery cell is completed. The battery cell inspection apparatus 100 may be an apparatus that applies high voltage to check leakage current of the battery cell 1, and for example, it may be a HPCD (high press current direction) apparatus.

The battery cell inspection apparatus 100 according to an embodiment of the present disclosure uses a push member 140 when the battery cell 1 is mounted on the support member 120 between the pressing plates 110 in a manner deflected to one side as will be described later, thereby preventing the folding problem of the terrace part 1b due to the deflection of the center of gravity of the cell, making it easier to grip the battery cell 1, and also making it easier to move the battery cell 1. The battery cell inspection apparatus 100 according to the present disclosure can be applied, for example, when mounting and inspecting a battery cell 1 having a shape in which the main body 1a protrudes in one direction.

The battery cell inspection apparatus 100 according to an embodiment of the present disclosure includes, for example, a plurality of pressing plates 110, a support member 120, a gripper 130, a push member 140, and a buffer member 150.

The plurality of pressing plates 110 may be, for example, a pair of pressing plates 110, wherein the pair of pressing plates 110 may be arranged in parallel, and arranged facing each other and spaced apart by a predetermined distance. One battery cell 1 may be inserted into the separation space between the pair of pressing plates 110. During the inspection process of the battery cell 1, swelling may occur due to expansion or gas generation of a cathode plate and an anode plate, wherein the pressing plates 110 serve to press the battery cell 1 and prevent swelling.

Although only a pair of pressing plates 110 is shown in FIG. 2, for example, each of 36 battery cells 1 may be disposed between the respective 36 pairs of pressing plates 110 and pressed.

The pressing plates 110 perform an operation of pressing or releasing the main body 1a of the battery cell 1. Such pressing plates 110 may be preferably formed of a metal material with high mechanical rigidity so as not to be deformed even under high temperature and high pressure, but the scope of the present disclosure is not limited to the pressing plates 110 made of metal. For example, the pressing plate 110 may be made of stainless steel, reinforced plastic, reinforced ceramic, reinforced glass, or the like.

One battery cell 1 may be inserted into the separation space between the pressing plates 110. Further, a support member 120 may be provided between the pressing plates 110 so that the inserted battery cell 1 is supported at a constant height. The support member 120 may be, for example, a tissue paper, and for example, it may be made of paper or thin plastic.

The support member 120 includes a mounting part to which the battery cell 1 is mounted and a fixing part fixed to the pressing plates 110. The mounting part has a concave shape by folding or bending the support member 120, and for example, has a V-shape or a U-shape, and may include fixing parts extending from both ends of the mounting part and fixing to the respective upper ends of the pressing plates.

One end of the support member 120 may be fixed to one of the pressing plates 110, the other end of the support member 120 may be fixed to the other one of the pressing plates 110, and the support member 120 may be folded between the two fixing parts of the support member 120 and the pressing plate 110, so that the battery cell 1 can be mounted thereto. At this time, the support member 120 has an open shape in each of the forward direction and backward direction from the ground in FIG. 2, and the electrode lead 1c of the battery cell 1 may be placed to be directed in both open directions of the support member 120.

The gripper 130 can grip the battery cell 1 and mount the battery cell 1 to the support member 120, and can again detach the battery cell 1 from the support member 120. For example, in the case of the pouch-type battery cell 1, the sealing part or optionally the terrace part of the edge of the main body of the battery cell 1 can be gripped by the gripper 130. This is for minimizing the generation of damages in the battery cell 1 by gripping the main body part of the battery cell 1 in which the electrode assembly is incorporated. The gripper 130 can be variously modified and changed in various environments in which the present disclosure is realized, for example it may have a structure that consists of one gripper for each battery cell 1 and captures a part of the battery cell 1, such as a terrace part, it may have a structure that consists of a pair and captures the sealing parts on both sides of the battery cell 1 or the terrace parts on both sides. The gripper 130 may be, for example, forceps-shaped, but it is sufficient if it can grip the battery cell 1, for example, grippers commonly used in the battery manufacturing process may be adopted. It can be realized in various shapes and structures in accordance with the environment to which the present disclosure is applied.

The gripper 130 may be removed from the space between the pressing plates 110 after the battery cell 1 inserted into the support member 120 and before the battery cell 1 is pressed by the pressing plates 110, but may be variously modified and changed in various environments in which the present disclosure is realized, such as being able to continue to capture the battery cell 1 even while pressing the battery cell 1.

The battery cell inspection apparatus 100 according to an embodiment of the present disclosure further includes a push member 140 that prevents the battery cell 1 mounted to the support member 120 from being deflected. The push member 140 is provided between the inner surface of at least one pressing plate 110 among the plurality of pressing plates 110 and the support member 120. That is, the push member 140 is provided between the support member 120 and at least one of the mutually opposing surfaces of the plurality of pressing plates 110.

Further, the push member 140 may include a bar 141 shaped to protrude from the pressing plate 110 toward the support member 120 and a head part 142 located at one end of the bar 141.

The shape of the head part 142 may be spherical as shown in FIG. 2, or may be plate-shaped. The present disclosure is not limited to those illustrated, and may be modified and changed in accordance with various environments in which the present disclosure is realized. Similarly, the bar 141 and the head part 142 of the push member 140 may be formed to be able to be coupled to each other, or can be modified and changed in various ways, such as the bar 141 and the head part 142 being formed integrally. All or part of the bar 141 of the push member 140 is inside the push member mounting part 111 of the pressing plate 110, but may protrude outside the pressing plate 110 when the push member 140 has to push the support member 120. The head part 142 of the push member 140 as well as the bar 141 is inside the push member mounting part 111 of the pressing plate 110, but may protrude outside the pressing plate 110 when the push member 140 has to push the support member 120. The material of the push member 140 may be, for example, a rigid plastic or metal (e.g., stainless steel).

As shown in the direction of the arrow in FIG. 2, the push member 140 may protrude from the pressing plate 110 toward the support member 120, and may return to its original state toward the pressing plate 110 again. The extent to which the push member 140 protrudes toward the support member 120 and/or retract toward the pressing plate 110 can be finely adjusted.

For example, as shown in FIG. 2, the push member 140 may be provided on the upper side of the inner side surface of any one of the pair of pressing plates 110. However, the present disclosure is not limited to those illustrated, and the push member 140 may be provided in the middle or lower part of the pressing plate 110.

Further, the other end of the push member 140 may be shaped to be attached to the inner surface of the pressing plate 110, the other end of the push member 140 may be shaped to be inserted by placing a concave part inside the pressing plate 110, and the push member 140 may be provided to penetrate the pressing plate 110. Further, various modifications and changes can be made, such as the other end of the push member 140 being coupled to other components other than the pressing plate 110.

On the other hand, when the battery cell 1 is a cell having a main body 1a protruding in one direction as shown in FIGS. 1 and 2, the center of gravity is deflected to one side, and thus, may be deflected to any one side of the pressing plates 110. At this time, a push member 140 is provided on the pressing plate 110 on the side where the battery cell 1 is deflected among the pair of pressing plates 110 (i.e., pressing plate facing the main body 1a of the battery cell 1) to correct the deflection of the battery cell 1.

A spring member (not shown) may be mounted to the end of the bar 141 of the push member 140 in the push member mounting part 111. Before the push member 140 protrudes toward the support member 120, in a state where the spring member is compressed, the push member 140 may be locked by being hooked to the push member mounting part 111 by a locking member (not shown) or the like. When the locking member is unlocked, the push member 140 may protrude toward the support member 120 by the elastic force of the spring member.

Alternatively, a small-sized motor that can control and move the bar 141 of the push member 140 is mounted to the push member mounting part 111 or mounted on the outside of the push member mounting part 111, and may be connected to the bar 141 of the push member 140.

Alternatively, various methods may be applied for the reciprocating movement of the push member 140, such as the push member 140 being able to connected to a pneumatic cylinder (not shown).

The push member 140 protrudes from the pressing plate 110 toward the support member 120 by a predetermined distance so as to push the support member 120, and then for example, when the battery cell 1 is to be pulled out from the support member 120, it can retract again toward the pressing plate 110 by a predetermined distance in the opposite direction. For example, the push member 140 including the head part 142 may perform a reciprocating motion in a direction perpendicular to mutually opposing surfaces of the plurality of pressing plates 110.

The buffer member 150 is used for preventing the battery cell 1 from being damaged when it directly touches the pressing plate 110 made of metal material, and can be provided on the inner surfaces facing each other of a pair of pressing plates 110. That is, a pair of buffer members 150 are provided between a pair of pressing plates 110, a support member 120 is provided between the pair of buffer members 150, and the battery cell 1 may be mounted on the support member 120.

In some cases, various modifications and changes can be made, such as a buffer member 150 being provided not only between the pair of pressing plates 110 but also on the outer surface of respective pressing plates 110. For example, a plurality (n+1, n is a natural number) of pressing plates 110 are arranged in parallel along one direction, a plurality (n numbers, n is a natural number) of support members 120 are placed between the plurality of pressing plates 110, and a plurality (n numbers, n is a natural number) of battery cells 1 are mounted, and then the plurality of pressing plates 110 can also move and press at a time.

The buffer member 150 may be in the shape of a pad that covers part or all of one surface of the pressing plate 110, but the present disclosure is not limited thereto, and it sufficient if it has a shape or structure that can prevent the battery cell 1 from being damaged due to excessive pressure or impact on the battery cell 1 when the battery cell 1 and the pressing plate 110 come into contact. Moreover, the buffer member 150 may be, for example, a urethane pad.

The battery cell inspection apparatus 100 further includes an inspection unit (not shown) that can be integrated inside or remotely accessed from the outside, so that the electrode lead 1c of the battery cell 1 placed on the support member 120 between the pressing plates 110 is electrically connected to measure the leakage current of the battery cell 1.

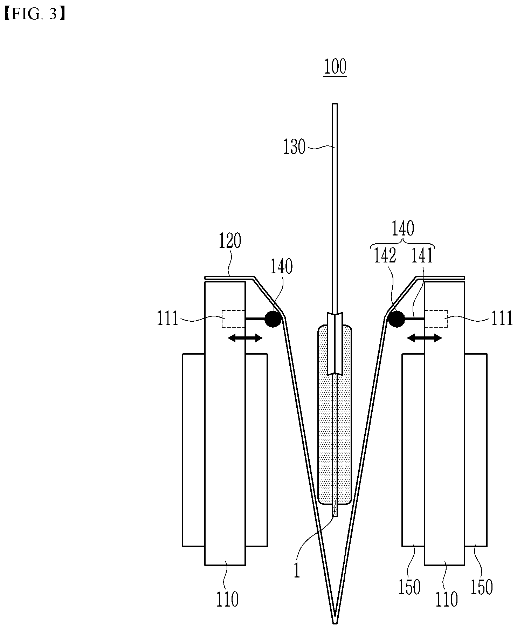

FIG. 3 shows a modification of the battery cell inspection apparatus 100 of FIG. 2. The battery cell inspection apparatus 100' of FIG. 3 includes push members 140 on both pressing plates 110 for each battery cell 1. By allowing push members 140 on both sides of the pressing plates 110 to push the support member 120 from both sides, the deflection of the battery cell 1 can be corrected. The battery cell inspection apparatus 100' of FIG. 3 can also be applied to inspect the battery cell 1 in the shape of a one-cup cell as shown in FIGS. 1 and 2, or can also be applied to inspect the main body 1a by mounting a double-cup cell type battery cell (not shown) protruding on both sides. Other matters and components will be described similarly with reference to those described above in FIG. 2.

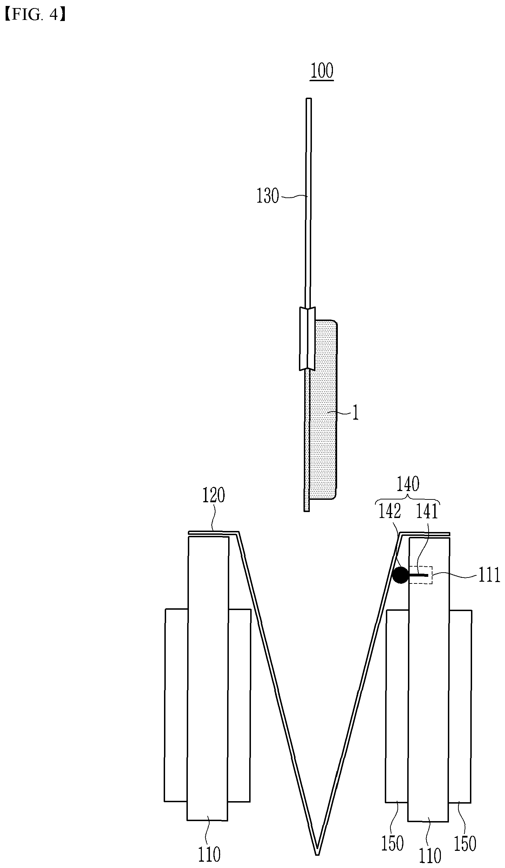

Next, referring to FIGS. 4 to 9, operations between the respective components of the battery cell inspection apparatus 100 of FIG. 2 will be described by way of example. Each step in the method for inspecting the battery cell 1 in the battery cell inspection apparatus 100 of FIG. 2 will be described by way of example.

First, referring to FIG. 4, the battery cell 1 is gripped by a gripper 130 (S110). At this time, the sealing part of the edge of the battery cell 1 (e.g., the sealing part of a pouch) or the terrace part of the battery cell 1 may be gripped with the forceps of the gripper 130. At this time, the battery cell 1 gripped by the gripper 130 is placed on the support member 120 provided within the pair of pressing plates 110.

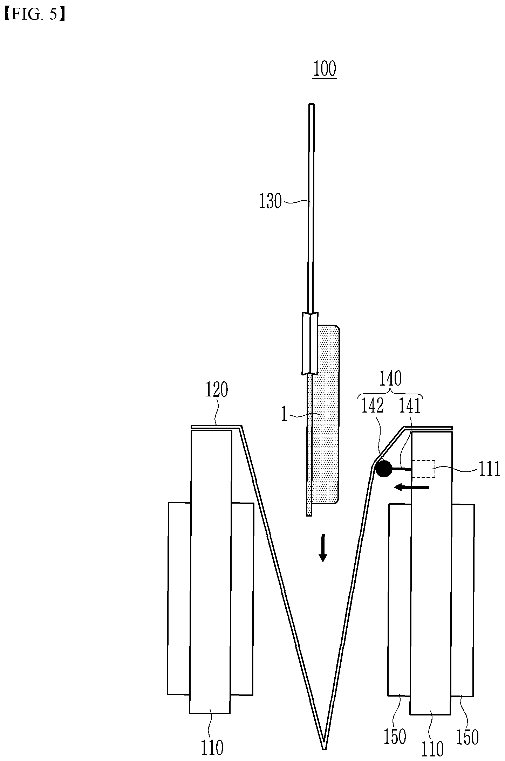

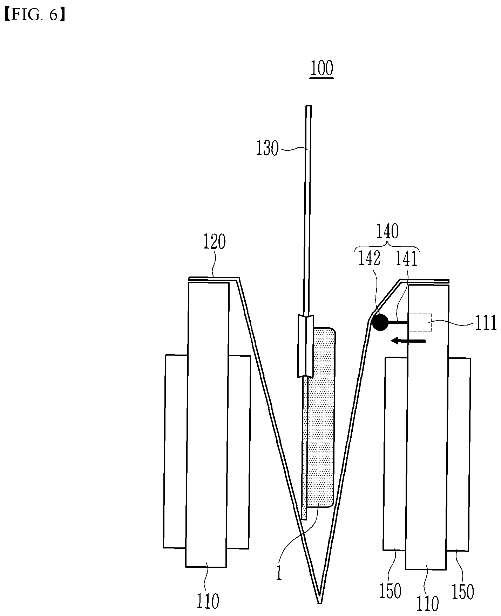

Next, referring to FIGS. 5 and 6, the battery cell 1 gripped by the gripper 130 is mounted on the support member 120 provided within the pair of pressing plates 110 (S120).

At this time, in step S120, the battery cell 1 gripped by the gripper 130 can be lowered into the support member 120 in the direction of the arrow (S121) and mounted. In some cases, on the contrary, the battery cell 1 gripped by the gripper 130 may remain as it is, while the pair of pressing plate 110 and the support member 120 may rise toward the battery cell 1, or a combination of both the case where the battery cell 1 is lowered by the gripper 130 and the case where the pressing plate 110 and the support member 120 are raised is also possible.

At this time, as described above in FIG. 2, in order to prevent the battery cell 1 from being deflected to one side, the push member 140 may protrude toward the support member 120 to push (support) the support member 120 (S122). As shown in FIG. 5, before the battery cell 1 is mounted on the support member 120, the push member 140 may in advance protrude toward the support member 120 and push (support) the support member 120. This may be a case in which the extent to which the push member 140 protrudes is predetermined so that the battery cell 1 can be erected vertically without being deflected, that is, so that it can be upright (vertically aligned). Alternatively, as shown in FIG. 6, the battery cell 1 is mounted on the support member 120, and simultaneously or subsequently, the push member 140 protrudes toward the support member 120 to push (support) the support member 120. This may mean that the push member 140 protrudes while the extent to which it protrudes is finely adjusted, until the battery cell 1 mounted on the support member 120 stands upright (vertically aligned) without being deflected. Alternatively, in some cases, it may be a combination of both the former and the latter.

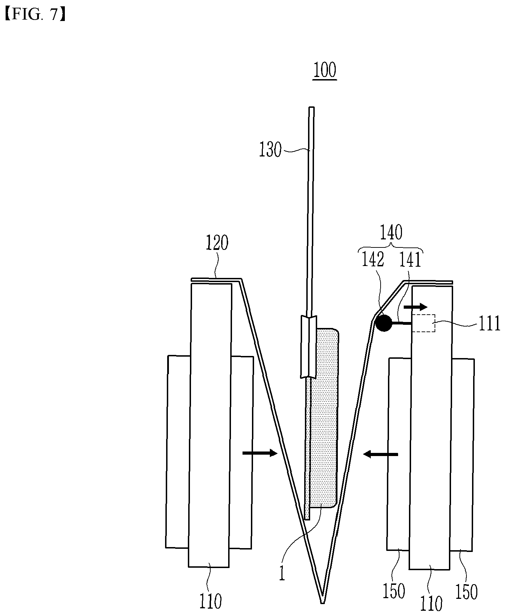

Next, referring to FIG. 7, the support member 120 on which the battery cell 1 is mounted is moved by a pair of pressing plates 110 toward the battery cell 1 (S130).

At this time, in step S130, the battery cell 1 is gripped as it is by the gripper 130, so that the battery cell 1 is prevented from being slid and deflected within the support member 120 (S131). In some cases, various modifications and changes can be made, for example, just before the battery cell 1 is pressed by the pressing plate 110, gripping the battery cell 1 by the gripper 130 is released so that the gripper 130 can be removed from the battery cell 1 (S132).

In some cases, in step S130, as the pair of pressing plates 110 move toward the battery cell 1, the protruding push member 140 may be slightly (adjusted) and returned toward the pressing plate 110 again (S133). When the distance between the pair of pressing plates 110 is long, the push member 140 protrudes and the battery cell 1 can be erected (vertically aligned) while pushing (supporting) the support member 120. However, when the distance between the pair of pressing plates 110 gradually narrows and the battery cell 1 is pressed as described later, the battery cell 1 may be able to stand upright (vertically aligned) even if the support member 120 is not pushed (supported) by the push member 140.

However, in some cases, step S133 may not be performed. If the battery cell 1 is pressed too tightly when pressing the battery cell 1 by a pair of pressing plates 110, rather, it may cause damage to battery cell 1, such as the case where swelling may occur in the battery cell 1. Thereby, even when the battery cell 1 is pressed with the pair of pressing plates 110, a certain amount of space remains between the support member 120 and the battery cell 1, and the push member 140 still protrudes so that there may be cases where the support member 120 must be pushed (supported). Alternatively, even if the push member 140 protrudes due to the difference in level from the pressing plate 110 caused by the buffer member 150, it may not interfere with the pressing of the battery cell 1.

Additionally or alternatively, various modifications and changes can be made, such as the push member 140 slightly retracting toward the pressing plate 110, but the extent to which the push member 140 protrudes may be finely adjusted.

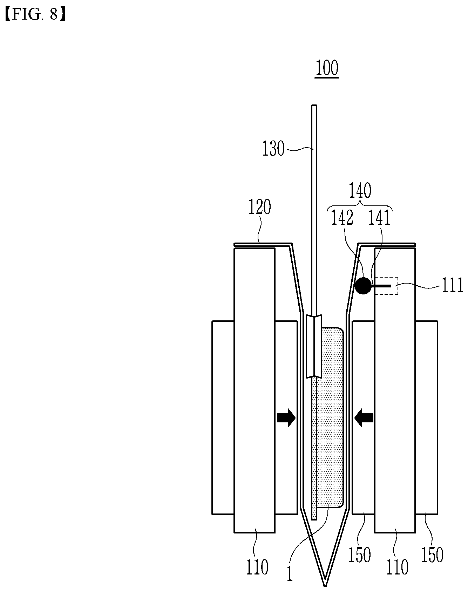

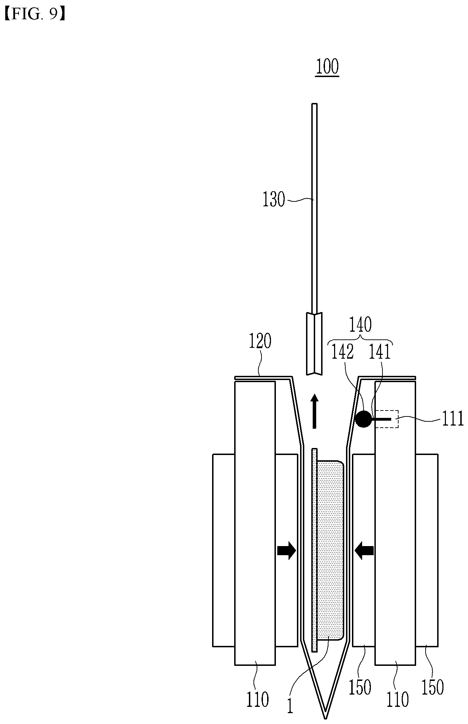

Next, referring to FIGS. 8 and 9, the battery cell 1 sandwiched between the pair of pressing plates 110 is pressed (S140). FIG. 8 shows a case where the battery cell 1 is pressed while the battery cell 1 is being gripped by the gripper 130. As described above in step S132, FIG. 9 shows a case where the battery cell 1 is pressed after the gripper is released from gripping the battery cell 1 and the gripper is removed from the battery cell.

At this time, in step S140, the battery cell 1 can be inspected by connecting an inspection unit (not shown) while pressurizing the battery cell 1. The type of inspection performed is not limited, and at least one of the various types of inspections performed in the normal manufacturing process of the battery cell 1 can be applied and performed in accordance with the environment in which the present disclosure is realized.

Further, as described above in FIG. 2, a buffer member 150 is provided on the mutually opposing surfaces of the pair of pressing plates 110, and thus, even if the pressing plate 110 is moved toward the battery cell 1 to press the battery cell 1, it is possible to prevent the battery cell 1 from being damaged.

Next, when the inspection of the battery cell 1 is completed, although not shown in the drawings of the present disclosure, the steps described above are performed in a reversed manner. In order to release the pressure on the battery cell 1, the pair of pressing plates 110 are moved in opposite directions as shown by the arrows in FIG. 7. Next, the battery cell 1 is moved in the opposite direction as shown by the arrow in FIG. 5 using the gripper 130 and removed from the support member 120. Since the details are opposite to those described above in FIGS. 4 to 9, a description thereof is omitted.

The invention has been described in detail with reference to preferred embodiments thereof. However, it will be appreciated by those skilled in the art that the scope of the present disclosure is not limited thereto, and various modifications and improvements can be made in these embodiment without departing from the principles and sprit of the invention, the scope of which is defined in the appended claims and their equivalents.

### [Description of Reference Numerals]

1: battery cell
1a: main body
1b: terrace part
1c: electrode lead
10: 100, 100': battery cell inspection apparatus
110: pressing plate
111: push member mounting part
120: support member
130: gripper
140: push member
141: bar
142: head part
150: buffer member

## Claims

1. A battery cell inspection apparatus comprising:
pressing plates that press a battery cell;
a support member disposed between mutually opposing surfaces of the pressing plates having the battery cell mounted thereon;
a gripper capable of gripping and moving the battery cell; and
a push member that can protrude from at least one of the pressing plates toward the support member and push the support member.

2. The battery cell inspection apparatus of claim 1, wherein:
the push member comprises,
a bar shaped so as to protrude toward the support member from at least one of the mutually opposing surfaces of the pressing plates; and
a head part located at one end of the bar and pushing the support member.

3. The battery cell inspection apparatus of claim 1, wherein:
the push member protrudes toward the support member between the at least one of mutually opposing surfaces of the pressing plates and the support member, and can retract toward the pressing plate again, so that the mounted battery cell can be prevented from being deflected in one direction.

4. The battery cell inspection apparatus of claim 1, wherein:
the push member already protrudes from the pressing plate before the battery cell is mounted on the support member, or
the battery cell is mounted on the support member, and simultaneously or subsequently, the push member protrudes from the pressing plate.

5. The battery cell inspection apparatus of claim 1, wherein:
during inspection of the battery cell, the push member is pushing the pressing plate in a protruding state.

6. The battery cell inspection apparatus of claim 1, wherein:
the push member is located on an upper part of at least one of the mutually opposing surfaces of the pressing plates.

7. The battery cell inspection apparatus of claim 1, wherein:
the support member comprises a mounting part to which a battery cell is mounted and a fixing part fixed to the pressing plates.

8. The battery cell inspection apparatus of claim 1, wherein:
the mounting part of the support member is V-shaped or U-shaped, and
the fixing part of the support member extends from both ends of the mounting part to be fixed to respective upper ends of the pressing plates.

9. The battery cell inspection apparatus of claim 1, wherein:
both ends of the support member can be fixed to the pressing plates, respectively, and the support member can be folded or bent between both fixing parts to mount the battery cell on the support member.

10. The battery cell inspection apparatus of claim 1,
further comprising buffer members that are respectively provided on mutually opposing surfaces of the pressing plates.

11. The battery cell inspection apparatus of claim 10, wherein:
the buffer member is a urethane pad.

12. The battery cell inspection apparatus of claim 1, wherein:
the battery cell has a main body that protrudes in one direction, and
the push member is provided on the pressing plate toward which the protruding main body of the battery cell is directed.

13. The battery cell inspection apparatus of claim 1, wherein:
the battery cell has a main body that protrudes in both directions, and
the push members are respectively provided on mutually opposing surfaces of the pressing plates.

14. The battery cell inspection apparatus of claim 1, wherein:
the push member is made of stainless steel, and
the support member is made of paper or plastic.

15. A battery cell inspection method comprising the steps of:
gripping the battery cell by a gripper;
mounting the battery cell gripped by the gripper on a support member between pressing plates facing each other;
moving the pressing plates toward the battery cell; and
inspecting the battery cell while pressing the battery cell with the pressing plates,
wherein a push member protrudes from the pressing plate to push the support member so that the mounted battery cell is prevented from being deflected.

16. The battery cell inspection method of claim 15, wherein:
the mounting the battery cell gripped by the gripper on a support member comprises lowering the battery cell gripped by the gripper onto the support member,
wherein the push member already protrudes from the pressing plate before the battery cell is mounted on the support member, or
the battery cell is mounted on the support member, and simultaneously or subsequently, the push member protrudes from the pressing plate.

17. The battery cell inspection method of claim 15, wherein:
during the inspecting the battery cell, the protruding push member is pushing the pressing plate.

18. The battery cell inspection method of claim 15, wherein:
in the moving the pressing plates toward the battery cell, and inspecting the battery cell while pressing the battery cell with the pressing plates, the extent to which the push member moves toward the pressing plate again to push the support member can be adjusted.

19. The battery cell inspection method of claim 15, wherein:
during the inspecting the battery cell, the state in which the gripper grips the battery cell is maintained as it is.

20. The battery cell inspection method of claim 15, wherein:
before the inspecting the battery cell, the method comprises releasing the grip of the battery cell and removing the gripper.
